# EUROPEAN PATENT APPLICATION

(11) **EP 0 621 635 A1**
(43) Date of publication of application: **26.10.1994**
(21) Application number: 94106178.0
(22) Date of filing: 21.04.1994
(51) Int. Cl.: H01L 25/18, H01L 25/07, H01L 23/495

(54) **Power transistor module**

(30) Priority: 23.04.1993 JP 97434/93; 27.07.1993 JP 184267/93; 28.10.1993 JP 269353/93
(71) Applicant: FUJI ELECTRIC CO. LTD., Kawasaki 210 (JP)
(72) Inventor: Yamada, Toshifusa, c/o Fuji Electric Co., Ltd., Kawasaki 210 (JP); Soyano, Shin, c/o Fuji Electric Co., Ltd., Kawasaki 210 (JP); Arai, Etsuo, c/o Fuji Electric Co., Ltd., Kawasaki 210 (JP); Watanabe, Manabu, c/o Fuji Electric Co., Ltd., Kawasaki 210 (JP); Igarashi, Seiki, c/o Fuji Electric Co., Ltd., Kawasaki 210 (JP)
(74) Representative: Hoffmann, Eckart, Dipl.-Ing.

(57) **Abstract**

A power transistor module comprises a circuit substrate, at least one pair of power transistor chips (Tr1, Tr2) mounted on said circuit substrate and each transistor chip having a first and a second main electrode and a control electrode, a flywheel diode (D1, D2) connected in antiparallel to said main electrodes of each power transistor chip, internal connection means for connecting one of said main electrodes of a first (Tr1) of said transistor chips to one of said main electrodes of the second transistor chip (Tr2) so as form the upper and lower arms of a bridge circuit, external connection terminals (C1, C2E1, E2, G1, G2) for connection to a main circuit, of which a first one (C1) is connected to the other one of said main electrodes of said first transistor chip (Tr1), a second one (C2E1) is connected to said internal connection means, and a third one (E2) is connected to the other one of said main electrodes of said second transistor chip (Tr2), and a first and a second auxiliary terminal (e1, e2) of which the first auxiliary terminal (e1) is connected to said internal connection means at a position same as the position at which the second external connection terminal (C2E1) is connected to it or nearer to said one main electrode of the first transistor chip (Tr1) than the latter, and the second auxiliary terminal (e2) is connected to the third external connection terminal (E2), wherein said internal connection means provides a predetermined wiring inductance (l1) between said one main electrode of the first power transistor chip (Tr1) on the one hand and the position at which said first auxiliary terminal (e1) is connected to it on the other hand. By this structure a surge generated at the time of the switching operation is suppressed, while at the same time, a balance is obtained in the switching characteristics between the upper and lower arms of the bridge when the internal wiring inductance l1 (l1=l2) is adjusted to have an appropriate value.

## Description

The present invention relates to a power transistor module for use in a power switching device, and more particularly to its internal wiring structure.

Recently, products with power transistor modules which have a bridge circuit construction with a number of transistor chips assembled in the same package with connections between the transistors are widely available on the market. IGBT's (Insulated Gate Bipolar Transistors) are used as the power switching elements, for example.

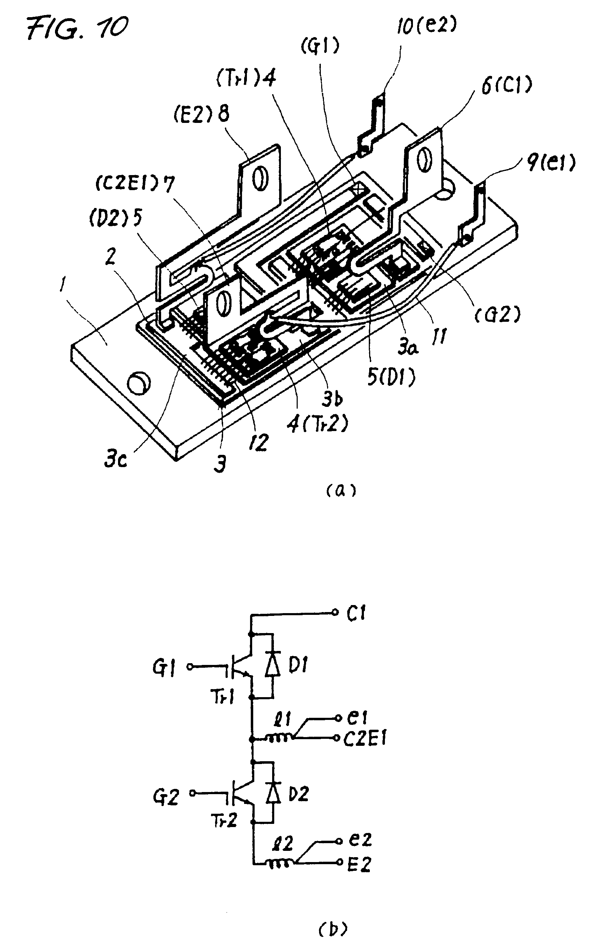

FIG. 10(a) and (b) are views of a prior art module construction using a half-bridge structure with two power transistor chips. In FIG. 10(a), the numeral 1 indicates a metal base for heat dissipation, numeral 2 indicates an insulating substrate for the circuit, numeral 3 indicates a copper foil circuit pattern formed on the insulating substrate, numeral 4 indicates a power transistor chip such as an IGBT chip (hereinafter referred to as "transistor"), numeral 5 indicates a flywheel diode chip connected in parallel with the transistor 4 (hereinafter referred to as "flywheel diode" or simply "diode"), numerals 6, 7 and 8 indicate external connection terminals for connecting the module to a main circuit, numerals 9 and 10 indicate auxiliary terminals taken out from the emitter of each transistor, numeral 11 indicates an internal lead connecting the auxiliary terminals 9 and 10 to the external connection terminals 7 and 8, respectively, and numeral 12 indicates bonding wires connecting the electrodes of transistors 4 and diodes 5 to the circuit pattern 3.

A circuit substrate such as a DBC substrate (Direct Bonding Copper substrate) or an insulated aluminum substrate may be adopted as the circuit substrate. The signs indicated in brackets in FIG. 10(a) correspond to the signs for each of the elements and terminals in the equivalent circuit in FIG. 10(b). Here, Tr1 and Tr2 indicate the power transistors for the upper and lower arms, D1 and D2 indicate the flywheel diodes, C1 indicates the collector terminal for the transistor Tr1, C2E1 indicates the common terminal for the emitter of the transistor Tr1 and the collector of the transistor Tr2, E2 indicates the emitter terminal for the transistor Tr2, e1 and e2 indicate auxiliary emitter terminals for the transistors Tr1 and Tr2 and G1 and G2 indicate the gate terminals.

In the construction of FIG. 10, the external connection terminal 6 is taken out from a collector pattern part 3a of the circuit pattern 3, on which the transistor Tr1 and the diode D1 are mounted, and the external connection terminal 7 is taken out from a collector pattern part 3b on which the transistor Tr2 and the diode D2 are mounted. Bonding wires 12 connect the pattern part 3b to the emitter electrode of the transistor Tr1 and the anode of the diode D1. Also, bonding wires 12 connect the pattern part 3c to the emitter electrode of the transistor Tr2 and the anode of the diode D2. The external connection terminal 8 (E2) is taken out from an emitter pattern part 3c for the transistor Tr2. Further, the auxiliary terminals 9(e1) and 10(e2) are connected via leads 11 to terminal plates forming the respective external connection terminals 7(C2E1) and 8(E2). Wiring inductances l1 and l2 shown in the equivalent circuit diagram in FIG. 10(b) are provided by these terminal plates between the position where the leads 11 are connected and the pattern parts 3b and 3c, respectively. Gate terminals G1 and G2 are connected via a gate pattern part connected to the gate electrodes of the transistors Tr1 and Tr2, respectively, by bonding wires.

The internal wiring inductances are provided for inducing a voltage due to the counter electromotive force at the time of turning off each transistor. By applying the induced voltage to the gate of the respective transistor, the drop in the gate voltage is weakened so that the di/dt of the output current is reduced by which a jumping up of the voltage between the gate and the emitter is suppressed. Further, it is necessary that the values for the wiring inductances l1 and l2 be adjusted to be appropriate for attaining a balanced switching operation between the transistors Tr1 and Tr2.

However, as the switching frequency is increased in accordance with the use of a high switching speed device, if the internal wiring structure of the prior art is retained without modification, the internal wiring inductance l1 connected to the auxiliary terminal e1 on the side of the transistor Tr1 causes the following detriments to the switching operation.

This will be described in the following with reference to FIG. 11. FIG. 11 shows the load current flow in the circuit of FIG. 10(b) during the switching operation. When transistor Tr1 is on and transistor Tr2 is off, the emitter current Ie of transistor Tr1 flows to the load L via the wiring inductance l1. On the other hand, when the transistor Tr1 turns off and its collector current Ic becomes Ic=0, as a result of the flywheeling operation of the diode D2, current If continues to flow as a flywheeling current via the diode D2 through the wiring inductance l1 and the load L. Therefore, no sufficient counter electromotive force is induced in the wiring inductance l1 and the jumping up of the voltage explained above cannot be sufficiently suppressed. As a result malfunctioning in the transistor drive circuit and externally connected equipment to be controlled is caused.

Contrary to this, looking at the lower arm transistor Tr2, the current which flows through the wiring inductance l2 on roe side of the auxiliary terminal e2 changes rapidly when the transistor Tr2 is turned on or off since there is no flywheeling current through the wiring inductance l2. If the correspondingly high counter electromotive force induced in the wiring inductance l2 is applied to the drive circuit for the transistor Tr2 via the auxiliary terminal e2, the voltage jumping can be suppressed.

In this way, with the internal wiring structure for the power transistor module in the prior art, when carrying out high speed switching, a large jumping or surge voltage is particularly generated in the upper arm including transistor Tr1. In addition, a difference occurs between the transistor Tr1 in the upper arm and the transistor Tr2 in the lower arm with regard to the amount of the jumping voltage at the time of the switching operation. This causes unstable switching characteristics of the module.

It is an object of the invention to solve the problems explained above and to provide a high power transistor module allowing a high frequency switching operation with no drastic changes in the voltage and current (dv/dt and di/dt) at the time of switching and a balanced operation of the upper and lower arms.

This object is achieved with a power transistor module as claimed.

According to the invention, a wiring inductance is connected in series between each of the transistors forming the upper and lower arms of a bridge circuit. Both, the corresponding external connection terminal and the auxiliary terminal for the first transistor are connected to portions or a portion of the wiring inductance opposite to the main electrode of the first transistor. According to this internal wiring structure, a flywheeling current through this wiring inductance which would prevent a sufficient counter electromotive force to be induced can be avoided.

Embodiments of the invention will be explained below with reference to the diagrammatic drawings, in which:
- FIG. 1: illustrates a first embodiment of the invention, where FIG. 1(a) is a perspective view of the internal wiring structure of the power transistor module and FIG. 1(b) is a diagram of its equivalent circuit;
- FIG. 2: is an enlarged view of the essential parts of the structure shown in FIG. 1(a);
- FIG. 3: is a perspective view of the internal wiring structure of a power transistor module according to a second embodiment of the invention;
- FIG. 4: shows detailed structural examples of the internal connecting member integral with the external connection terminal as used in the first embodiment of this invention, where FIG. 4(a) and (b) show side views of examples of different structures and FIG. 4(c) and (d) show connection structures for the auxiliary terminal connecting leads;
- FIG. 5: shows the detailed structure of the bridge shaped internal connecting member used in the second embodiment of this invention, where FIG. 5(a) is a perspective view of the whole member and FIG. 5(b) is a view with a terminal block attached;
- FIG. 6: illustrates a third embodiment of this invention, where FIG. 6(a) is a plan view of the internal wiring of the power transistor module, FIG. 6(b) is a side view of the structure and FIG. 6(c) is a diagram of its equivalent circuit;
- FIG. 7: shows positioning marks indicating positions for the connection of the lead for connecting the emitter pattern part of the pattern in FIG. 6 to the auxiliary terminal, where FIG. 7(a) is a diagram of round pattern marks and FIG. 7(b) is a diagram of a pattern with slit shaped marks;
- FIG. 8: is a view of a package construction suitable for use with the power transistor modules in each of the embodiments where FIG. 8(a) is a cut-away side view and FIG. 8(b) is a bottom view thereof;
- FIG. 9: is a view of the structure of a practical example for a third embodiment of this invention, where FIG. 9(a) is a plan view of the internal wiring structure and FIG. 9(b) is a diagram of the equivalent circuit;
- FIG. 10: illustrates the structure of a prior art power transistor module where FIG. 10(a) is a perspective view showing the construction of the internal wiring structure for the module and FIG. 10(b) is a diagram of its equivalent circuit;
- FIG. 11: is a circuit diagram for explaining the switching operation of the structure in FIG. 10;
- FIG. 12: is a circuit diagram for explaining the switching operation for an embodiment of this invention; and
- FIG. 13: shows the voltage and current waveforms while the power transistor module is switching, where FIG. 13(a) shows the operating waveforms for the lower arm transistor Tr2, FIG. 13(b) shows the operating waveforms for the upper arm transistor Tr1 using the construction of this invention and FIG. 13(c) shows the operating waveforms for an upper arm transistor Tr1 using the prior art construction in FIG. 7.

Parts in each of the figures which correspond to parts shown and explained above with respect to FIG. 10 are given the same reference signs.

### First Embodiment:

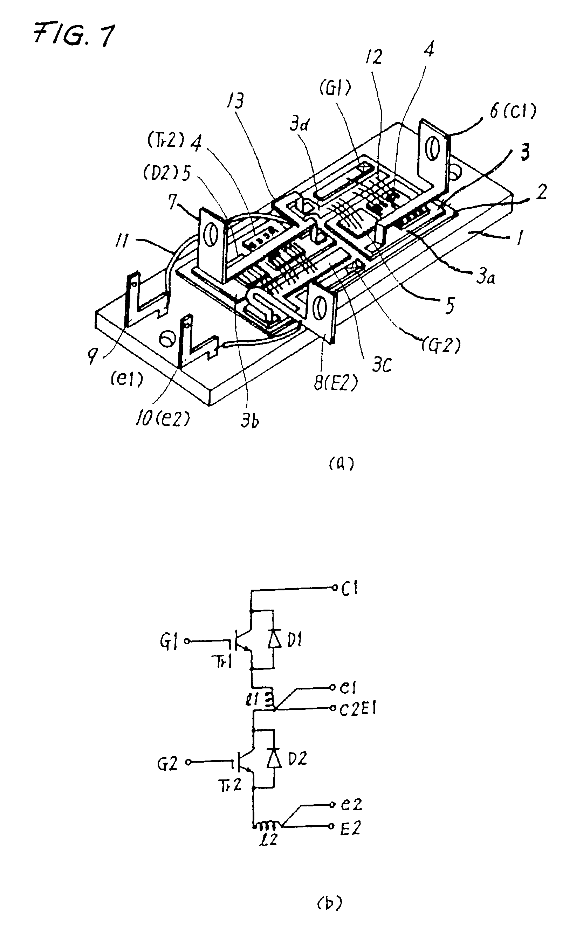

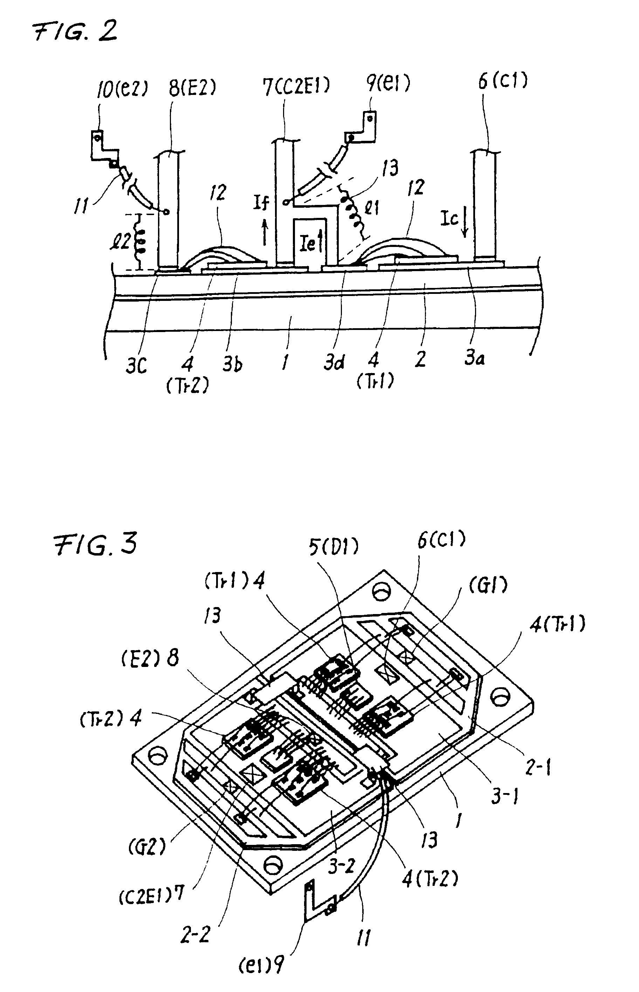

FIGs 1(a) and (b) and FIG. 2 show a first embodiment of the invention. In this embodiment, an emitter pattern part 3d for a transistor Tr1 in the upper arm of a half bridge and a collector pattern part 3b for a transistor Tr2 in the lower arm are provided as separate parts of a copper foil pattern 3 formed on an insulating substrate 2 . These pattern parts are connected together via an internal connecting member 13 which is integrally formed as a part of an external connection terminal 7 (C2E1) taken out from the pattern part 3b. Moreover, an auxiliary terminal 9 (e1) for the transistor Tr1, is connected, via a lead 11, to the point at which the external connection terminal 7 (C2E1) branches off the internal connecting member 13. Other aspects of the construction are the same as those for FIG. 10(a), i.e. the first transistor Tr1 and the diode D1, and the transistor Tr2 and the diode D2 are mounted on the separately formed pattern parts 3a and 3b respectively, with an external connection terminal 6 (C1) taken out from the pattern part 3a and an external connection terminal 7 (C2E1) taken out from the pattern part 3b. Also, the emitter electrode of the first transistor Tr1 and the anode of the diode D1 are connected to the emitter pattern part 3d via bonding wires 12, whereas the emitter electrode of the first transistor Tr2 and the anode of the diode D2 are connected to the emitter pattern part 3c via bonding wires 12. The external connection terminal 8 (E2) for the transistor Tr2 is taken out from the emitter pattern part 3c, with an auxiliary terminal 10 (e2) being connected to this external connection terminal 8 via a lead 11.

Here, the wiring inductance l1 which is shown in the equivalent circuit in FIG. 1(b) is provided by the internal connecting member 13. Its dimensions (length and width) are chosen such that based on the transistor chip characteristics and the switching device operating conditions the wiring inductance l1 as well as the wiring inductance l2 between the emitter pattern 3c and the point at which the auxiliary terminal 10 (e2) is connected (via lead 11) to the external connection terminal 8 (E2) for the transistor Tr2 in FIG. 1 have the optimum value (l1=l2).

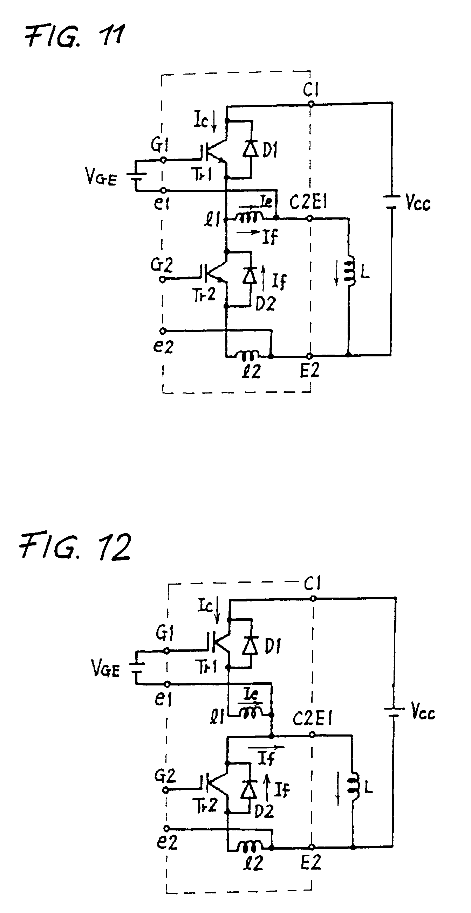

With the above construction, as is illustrated in FIG. 12, when transistor Tr1 is on and transistor Tr2 is off, the current Ie of transistor Tr1 flows via the internal connecting member 13 (inductance l1) to the external connection terminal 7(C2E1), from which it flows to an external load. On the other hand, if the transistor Tr1 turns off, a flywheeling current If flows to the external load via the external connection terminal 7 without flowing through the internal connecting member 13 (inductance l1). The current change in the wiring inductance l1 causes a counter electromotive force to be generated. By applying this to the gate of the transistor Tr1 via the auxiliary terminal e1, a voltage spike generated in response to the switching operation can be suppressed under the same conditions as for the lower arm transistor Tr2. This ensures balanced switching characteristics between the upper and lower arms.

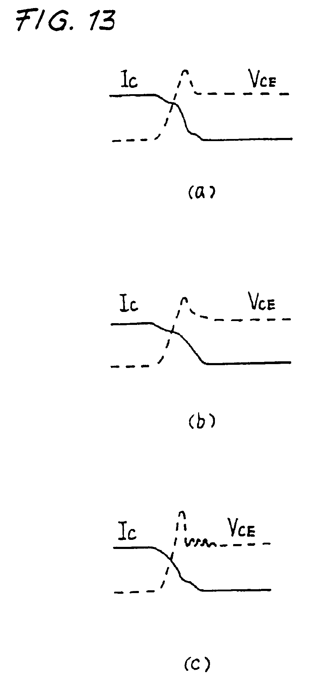

FIG. 13(a), (b) and (c) illustrate waveforms of the voltage and current in the main circuit during switching. FIG. 13(a) shows the operating waveform for the transistor Tr2 of the lower arm, FIG. 13(b) shows the operating waveform for the transistor Tr1 of the upper arm of the construction in this embodiment, and FIG. 13(c) shows the operating waveform for the transistor Tr1 in the prior art construction shown in FIG. 10. As becomes clear from this diagram, as regards the abrupt switching surge which occurred during the switching operation of the transistor Tr1 in the prior art construction, by adopting the internal wiring structure of the invention, in addition to the switching surge being alleviated, a more balanced switching operation where the operating waveforms for the transistors Tr1 and Tr2 are almost the same is obtained.

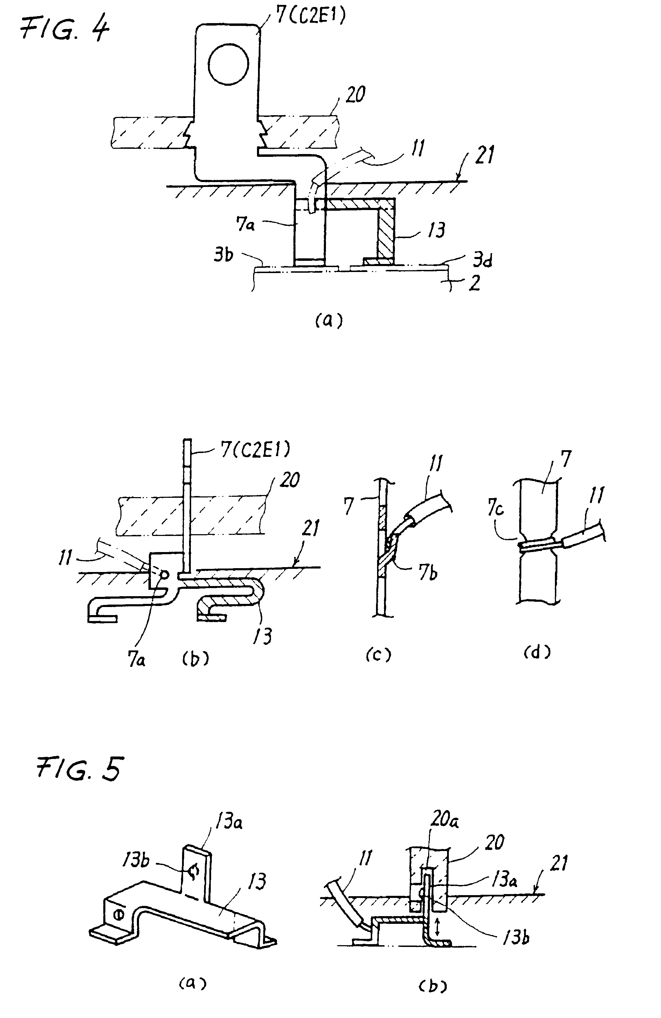

FIG. 4(a) to (d) show in more detail specific structural examples of how the external connection terminal 7 (C2E1) is formed integrally with the internal connecting member 13. First, in FIG. 4(a), the external connection terminal 7 is branched off the internal connecting member 13 at an intermediate point thereof. A lead insertion hole 7a for soldering the lead 11 for the auxiliary terminal e1 is formed at this branch-off point. The wiring inductance l1 is provided by the part of the internal connecting member 13 (the part with hatched lines) connecting this point to the emitter pattern part 3d. The internal connecting member 13 is then buried in a gel filling material (silicone gel) 21 which is injected into the package so as to provide protection from mechanical stress caused by heat cycling in actual use.

FIG. 4(b)shows an example where the length of that part of the internal connecting member 13 that provides the wiring inductance l1, i.e. the length between the point from which the external connection terminal 7 is branched off and the emitter pattern part 3d, has been extended lengthwise to obtain the desired value for the wiring inductance l1. Here, the terminal 13 is bent into a hairpin shape in the horizontal direction and buried under a gel filling material 21 in the same way as in FIG. 4(a).

FIG. 4(c) and (d) show alternative structures for connecting the external connection terminal 7 and the lead 11. In FIG. 4(c), a part of the external connection terminal 7 is cut for providing a tongue 7b, which then holds the lead for soldering. In FIG. 4(d), notches 7c are provided on both sides of the external connection terminal 7 around which the lead is wound for soldering.

### Second Embodiment

FIG. 3 shows a second embodiment of the invention. In this embodiment, the upper and lower arms both have two transistors chips connected in parallel. Also, insulation layers 2-1 and 2-2 for the circuit pattern 3-1 for the upper arm and the circuit pattern 3-2 for the lower arm are individually provided on a heat dissipating metal base 1. The circuit patterns 3-1 and 3-2 are connected together via a bridge-shaped internal connecting member 13. An auxiliary terminal 9(e1) is connected at a position at which the desired wiring inductance l1 (refer to the equivalent circuit in FIG. 1(b)) is provided by the internal connecting member 13. The external connection terminal 7 (C2E1) for the main circuit, which is formed as a part separate from the internal connecting member 13, is taken out directly from the emitter pattern part of the circuit pattern 3-2 on which the transistor Tr2 and diode D2 are mounted.

The operation of this embodiment brings about the same results as those of the first embodiment. By adjusting the value of the wiring inductance l1 provided by the bridge shaped internal connecting member 13 so as to get an appropriate value, in the same way as in the first embodiment, the switching surge in the main circuit can be suppressed and a more balanced operation between the upper and lower arms can be achieved.

FIG. 5(a) and (b) illustrate a specific supporting structure for the bridge shaped internal connecting member 13. A support tab 13a extends upward from a middle part of the terminal which is bent into a modified U-shape, and a projection 13b is formed on the support tab 13a. As is shown in (b), the support tab 13a is loosely inserted into a groove 20a formed in a terminal block 20 (support member for the external connection terminal) so that the internal connecting member 13 is supported by the terminal block 20 with the projection 13b of the support tab 13a engaging the terminal block. By using this support structure slight shifts in the vertical direction can be accommodated for so that the bridge shaped internal connecting member 13 can be stably held for reflow soldering onto the circuit pattern at a predetermined position. This bridge-shaped internal connecting member 13 is then buried as an assembly in a gel filling material 21 which is injected into the package in the same way as that described in FIG. 4.

It is to be noted that two bridge shaped internal connecting members 13 are shown in Fig. 3, one on each side. One of them provides the desired wiring inductance and would be sufficient for connecting the emitter of Tr1 to the collector of Tr2. The other is only for providing a symmetric current flow and need not necessarily be provided.

### Third Embodiment

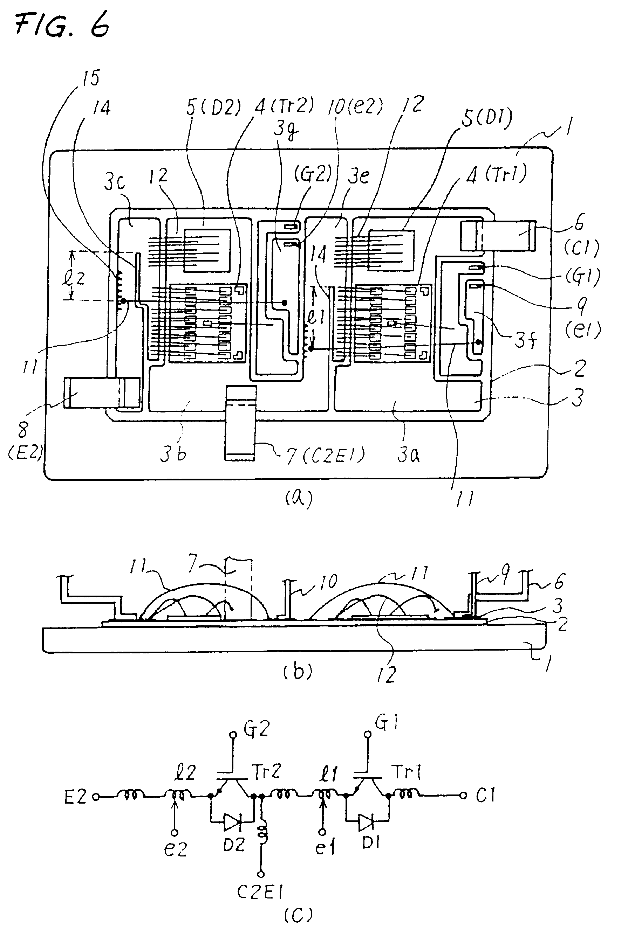

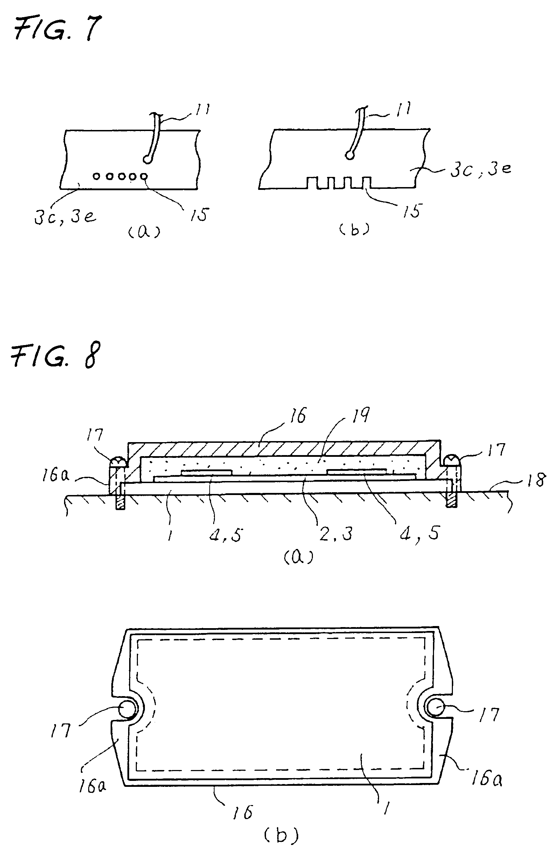

FIG. 6 (a), (b) and (c) and FIG. 7 show a third embodiment of the invention. In this embodiment, the transistors Tr1 and Tr2 and the flywheel diodes D1 and D2 are mounted on the pattern parts 3a and 3b formed separately on the circuit substrate in the same way as in FIG. 10. The external connection terminals 6 (C1) and 7 (C2E1) are taken out from the pattern parts 3a and 3b, respectively, and the external connection terminal 8 (E2) for the transistor Tr2 is connected to the emitter pattern part 3c which is connected to the emitter electrode of the transistor Tr2 and the anode of the diode D2 by bonding wires 12. There is also an emitter pattern part 3e for the transistor Tr1 joined to the chip mounting pattern part 3b for the transistor Tr2 with this pattern part 3e being connected to the emitter electrode of the transistor Tr1 and the anode of the diode D1 by bonding wires 12.

On the other hand, the auxiliary terminals 9 (e1) and 10 (e2) for the transistors Tr1 and Tr2 are taken out from pattern parts 3f and 3g which are formed separately from the aforementioned pattern parts. Moreover, leads 11 (aluminum wires) connect these pattern parts 3f and 3g to wiring inductance regions of the emitter pattern parts 3e and 3c, respectively. As shown in the figure, slits 14 are cut into the emitter pattern parts 3c and 3e such as to form a hairpin shaped structure for the current paths. Bonding wires 12 taken out from the respective diode and transistor are bonded onto the one side of this hairpin structure. The other side of this hairpin structure is the inductance region which provides an internal wiring inductance of a desired value in the same way as previously described in embodiments 1 and 2. By leads 11 these inductance regions are connected to the pattern parts 3f and 3g, respectively. One end of each lead 11 is bonded within the respective inductance region at a position such that wiring inductances l1 and l2 having the desired values are obtained.

Slight changes can be made in the values of the wiring inductances l1 and l2 by shifting the position at which the respective lead 11 is connected along the current paths formed in the pattern parts 3c and 3e. As is shown in the figure, positioning marks 15, which are easy to see, are provided at equal intervals along the inductance regions to indicate experimentally determined positions for the connection of the lead 11. Since such positioning marks can be easily recognized, desired connecting positions for the bonding work can be easily instructed.

Specific examples of these marks 15 are shown in FIG. 7(a) and (b). In FIG. 7(a) equally spaced round holes are formed along the inductance region of the pattern parts 3c and 3e and in FIG. 7(b) equally spaced slits are formed along the edge of the pattern parts 3c and 3e. In both examples the marks are used as indices for indicating or recognizing the bonding position for the lead 11 being bonded.

Providing the wiring inductances l1 and l2 at the emitter pattern part for each of the transistors as in this third embodiment has the following benefits. With the kind of construction in the first and second embodiments, where the desired inductances l1 and l2 are provided by an internal connecting member formed at an external connection terminal or as a separate bridge shaped internal connecting member, it is necessary for the shape of the connecting member or the terminal itself to be newly designed and manufactured each time there is a change in the characteristics of the transistors which requires a change in the value of the wiring inductance. This means that no standardized elements can be used even for a systematic production of the power transistor modules. On the contrary, according to the third embodiment, in addition to allowing the same terminals to be used for each of various transistor modules with different specifications, the appropriate internal wiring inductance can be obtained simply by varying the connecting position of the lead on the circuit pattern.

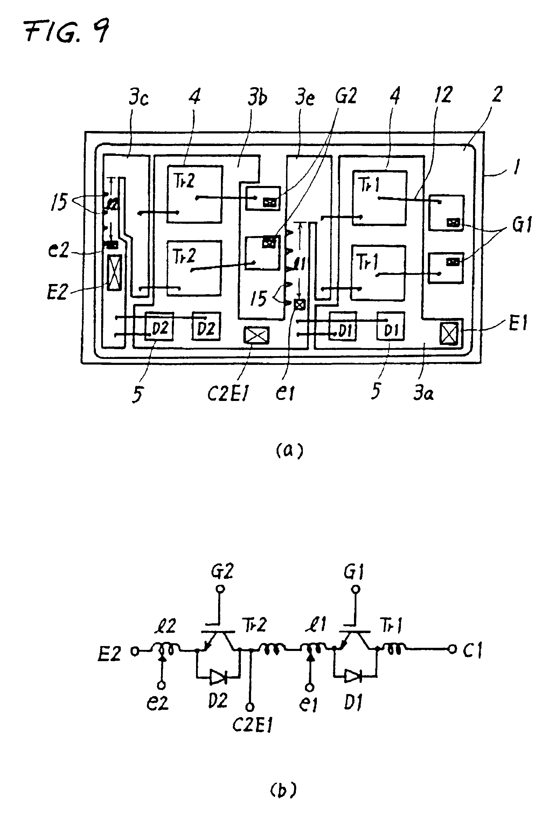

FIG. 9(a) and (b) show a modification of the examples of FIG. 6. In this embodiment, in particular, the external connection terminal E2 for the transistor Tr2 is on the emitter pattern part 3c, and is taken out from a point which is directly adjacent to the auxiliary terminal e2 connected to the inductance region. In this way, as will be seen from a comparison between the equivalent circuits in FIG. 6(c) and FIG. 9(b), the wiring inductance between the external connection terminal E2 and the auxiliary terminal e2 becomes almost zero.

By using this wiring structure, the inductance distribution of the wiring circuits on both sides of the transistor Tr1 in the upper arm is equal to that of the transistor Tr2 in the lower arm . This gives better balance and enhanced stability to the switching characteristics for the transistors Tr1 and Tr2.

A package structure suitable for use with the power transistor modules of each of the embodiments described above is shown in FIG. 8(a) and (b). In these figures, the package is made up of a metal base 1 on which the circuit assembly of each of the embodiments (comprising elements such as the transistors, the flywheel diodes and external connection terminals) is provided with a circuit substrate between them, and a resin case 16. It is then fixed in place on a heatsink such as a cooling block fin via fixing screws 17 when used. The resin case 16 is then filled up with sealing resin 19 to protect the elements such as the semiconductor chips.

The terminal blocks mentioned in the above description of the embodiments and not illustrated here, are attached to the upper surface of the resin case 16.

The outer edge of the metal base 1 is laid onto a stepped peripheral edge part 16a of the resin case 16 where it is glued with adhesive. Moreover, slots are formed on both sides of both the metal base 1 and the resin case 16, as can be seen in FIG. 8(b), so that the two members can then be screwed together by screws 17.

In a package with this kind of structure, the bottom of the metal base 1 closely contacts the upper surface of the heatsink 18 when the package of the transistor module is attached to the heatsink 18 with the metal base 1 and the resin case 16 fastened together through the fastening screws 17. Therefore there is no fear that the fitting of the metal base 1 and the resin case 16 will be separated. In addition, as the metal base 1 is required only to have a minimum external dimension necessary for mounting of the internal circuit structure, material can be saved.

With the transistor modules for each of the embodiments described above, a half bridge circuit assembly comprising two power transistor chips Tr1 and Tr2 (or two pairs of power transistor chips) internally connected together in series is incorporated in a single package. However, rather than only one, two or more half bridge circuit assemblies could be incorporated in the same package with each of the half bridge sections connected together internally so as to provide a single phase full bridge or a three phase full bridge circuit made up of, for example, four, or six power transistor modules.

As will be understood by those skilled in the art, although in the embodiments explained above separate flywheel diode chips are employed these diodes need not be separate components but may for instance be integrated into the power transistor chips.

According to each of the above constructions for the power transistor module, as is shown in the equivalent circuit in FIG. 12, a wiring inductance l1 is connected in series between each of the transistors Tr1 and Tr2, with an auxiliary emitter terminal e1 for the transistor Tr1 being taken out from this inductance l1. According to this internal wiring structure, when the transistor Tr1 is on, the emitter current Ie flows to the load L through the wiring inductance l1. As the transistor Tr1 is turning off, a flywheeling current If flows from the external connection terminal C2E1 to the load L without flowing through the wiring inductance l1. In this way, as is also the case for the time of the switching operation of the transistor Tr2 on the lower arm side, a counter electromotive force is induced as a result of the current change in the wiring inductance l1. By applying this counter electromotive force to the gate of the transistor Tr1 via the terminal e1, a voltage spike generated upon turning off can he suppressed It follows that, at the internal connecting member that branches off the external connection terminal C2E1 and connects to the emitter pattern part for the transistor Tr1, the bridge type connecting member connecting the patterns parts for the transistors Tr1 and Tr2 with each other and at the inductance region of the emitter pattern part, by choosing the most appropriate values for the wiring inductances l1 and l2 in accordance with the characteristics of the transistor chips Tr1 and Tr2 and the operating conditions of the switching device, the switching surge which accompanies the switching operation may be suppressed, a more balanced switching operation between the transistors Tr1 and Tr2 may be attained so as to obtain a transistor module with stable switching characteristics.

In this case, the value for the wiring inductances l1 and l2 is in the order of a few nH to 10 nH which may be provided by utilizing the self-inductance of a conducting (copper) bar of the internal connecting member or a circuit pattern for the circuit substrate. The actual effects of the wiring inductance may be confirmed by experiment. In design, however, the inductance value may be calculated from the following equation assuming that the inductance providing member is a thin plate with a rectangular cross section (width a, thickness b, length l):

$\text{L=2/3a2 x [3a2 x l x ln(l + (12 + a2)1/2)/a) - (l2 + a2)3/2 + 3l2 x ln(a + (a2 + l2)1/2)/1) + l3 + a3] x 10-7 - k x 1 x b/a x 10-7 [H]}$

where k is an experimental coefficient.

## Claims

1. A power transistor module comprising
a circuit substrate,
at least one pair of power transistor chips (Tr1, Tr2) mounted on said circuit substrate and each transistor chip having a first and a second main electrode and a control electrode,
a flywheel diode (D1, D2) connected in antiparallel to said main electrodes of each power transistor chip,
internal connection means for connecting one of said main electrodes of a first (Tr1) of said transistor chips to one of said main electrodes of the second transistor chip (Tr2) so as to form the upper and lower arms of a bridge circuit,
external connection terminals (C1, C2E1, E2, G1, G2) for connection to a main circuit, of which a first one (C1) is connected to the other one of said main electrodes of said first transistor chip (Tr1), a second one (C2E1) is connected to said internal connection means, and a third one (E2) is connected to the other one of said main electrodes of said second transistor chip (Tr2), and
a first and a second auxiliary terminal (e1, e2) of which the first auxiliary terminal (e1) is connected to said internal connection means at a position same as the position at which the second external connection terminal (C2E1) is connected to it or nearer to said one main electrode of the first transistor chip (Tr1) than the latter, and the second auxiliary terminal (e2) is connected to the third external connection terminal (E2),
wherein said internal connection means provides a predetermined wiring inductance (l1) between said one main electrode of the first power transistor chip (Tr1) on the one hand and the position at which said first auxiliary terminal (e1) is connected to it on the other hand.

2. The module according to claim 1, wherein said one main electrode of the first transistor chip (Tr1) is an emitter electrode, said one electrode of the second transistor chip (Tr2) is a collector electrode, said external connection terminals (C1, C2E1, E2, G1, G2) are connected to respective pattern parts of a conductive circuit pattern provided on said circuit substrate separately for each transistor chip (Tr1, Tr2), and said wiring inductance (l1) is provided between the point at which said first auxiliary terminal (e1) is connected it and an emitter pattern part for the said first transistor chip (Tr1).

3. The module according to claim 1 or 2, wherein said first auxiliary terminal (e1) is connected to said internal connection means at a position between said one main electrode of said first power transistor chip (Tr1) and said second external connection terminal (C2E1) a wiring inductance (l1) being provided at least between said first auxiliary terminal (e1) and said one main electrode.

4. The module according to any of the preceding claims, wherein said internal connection means and said second external connection terminal are formed as a single body.

5. The module according to any one of claims 2 to 4, wherein said internal connection means comprises a bridge shaped connection member (13) connected between an emitter pattern part (3d) for said first transistor chip (Tr1) and a collector pattern (3b) part for said second transistor chip (Tr2) and said first auxiliary terminal (e1) is connected to a point on said connection member.

6. The module according to claim 5, wherein said bridge shaped internal connection member (13) is loosely supported to allow its vertical movement by a terminal block (20) as a supporting member of said second external connection member.

7. The module according to claim 2 or 3, wherein said internal connection means is a pattern part of said circuit pattern integrally formed with the emitter pattern part (3e) for said first transistor chip (Tr1) and the collector pattern part (3b) for said second transistor chip (Tr2).

8. The module according to claim 7, wherein said wiring inductance (l1) is provided by an inductance region formed by means of a slit (14) dividing the emitter pattern part (3e) for the first transistor chip (Tr1).

9. The module according to claim 7 or 8, wherein a wiring inductance (l2) is provided by an inductance region formed by means of a slit (14) dividing the emitter pattern part (3c) for the second transistor chip (Tr2).

10. The module according to claim 8 or 9, wherein positioning marks indicating positions for connection of said first auxiliary terminal (e1) are formed along the inductance region each mark corresponding to another value of said wiring inductance.

11. The module according to any one of claims 7 to 10, wherein the connection position for said third external connection terminal (E2) to the emitter pattern part for said transistor chip (Tr2) on the lower arm side is next to the connection position for said second auxiliary terminal (e2).

12. The module according to any one of the preceding claims, wherein said internal connection means is buried in a gel filling material injected into a package comprising said module.
